# EUROPÄISCHE PATENTANMELDUNG

(11) **EP 1 310 986 A1**
(43) Veröffentlichungstag der Anmeldung: **14.05.2003**
(21) Anmeldenummer: 01126708.5
(22) Anmeldetag: 08.11.2001
(51) Int. Cl.: H01L 21/00

(54) **Chipträgerplatten-Wechselmechanismus**

(71) Anmelder: F & K Delvotec Bondtechnik GmbH, 85521 Ottobrunn (DE)
(72) Erfinder: Farassat, Farhad, Dr., 82024 Taufkirchen (DE)
(74) Vertreter: Heinze, Ekkehard, Dipl.-Phys. Dr.

(57) **Zusammenfassung**

Chipträgerplatten-Wechselmechanismus, insbesondere zur Verwendung in einer Hybrid-Chipbondmaschine (1), mit: einer Mehrzahl von Chipträgerplatten (12), einem Magazin (10) zur Speicherung der Mehrzahl von Chipträgerplatten (12), einer Transportanordnung (40), die eine erste und zweite Einspanneinrichtung (42, 44) aufweist, welche an einem bewegbaren Halter (46) angeordnet sind, wobei die Transportanordnung dazu ausgebildet ist, eine ausgewählte Chipträgerplatte aus dem Magazin zu entnehmen, sie einer Arbeitsstation, insbesondere einem Chipausstechsystem (8), der Chipbondmaschine zuzuführen, sie aus der Arbeitsstation nach einem Arbeitsgang wieder aufzunehmen und sie im Magazin abzulegen, einer Steuereinrichtung zum Weiterbewegen der Chipträgerplatte in dem Magazin derart, daß die ausgewählte Chipträgerplatte an einem Abholpunkt zur Abholung aus dem Magazin positioniert wird, und einer Steuereinrichtung zum Bewegen des Halters der Transportanordnung, wobei die erste und zweite Einspanneinrichtung (42, 44), insbesondere in vertikaler Ausrichtung miteinander, übereinander an dem Halter (46) angeordnet und einzeln zur Freigabe oder zum Festklemmen jeweils einer Chipträgerplatte in ein und derselben Winkelstellung des Halters ausgebildet sind.

## Beschreibung

Die Erfindung betrifft einen Chipträgerplatten-Wechselmechanismus für eine Hybrid-Chipbondmaschine, insbesondere eine automatische Hybrid-Chipbondmaschine, nach dem Oberbegriff des Anspruchs 1.

Eine Hybrid-Chipbondmaschine dient dazu, Halbleiterchips verschiedener Typen und insbesondere Größen auf ein Substrat zu bonden. In der Chipzuführungsstufe werden Chips jeweils einzeln einem Chipausstechsystem zugeführt, um ausgestoßen und anschließend von einem geeigneten Aufnahmewerkzeug aufgenommen zu werden. Eine Reihe von verschiedenen Chipzuführungssystemen ist bekannt und in Benutzung, und die Wahl des Chipzuführungssystems wird hauptsächlich durch die Größe des Chips bestimmt. Vorhandene Chipzuführungssysteme umfassen beispielsweise Waferringe bzw. Trägerfilmrahmen und Waffelschalen (Wafflepacks) oder auch sogenannte Gelpacks, die jeweils in verschiedenen Größen verfügbar sind.

Beim automatischen Hybrid-Chipbonden muß die Maschine fähig sein, eine Reihe von verschiedenen Größen oder Typen von Chips mit einem möglichst kurzen Wechselintervall und entsprechend kurzem Betriebszeitverlust der Maschine zu handhaben, wenn ein Wechsel von einer Chipgröße oder einem Chiptyp zu einem anderen stattfindet.

Jeder einzelne Wafer, jeder Trägerfilmrahmen oder jedes Wafflepack oder Gelpack eines bekannten Chipzuführungssystems enthält Chips nur eines Typs oder einer Größe. Wenn es beim Bonden notwendig wird, von einem Chiptyp oder einer Chipgröße zu einer anderen zu wechseln, ist es auch erforderlich, zu einer anderen Chipträgerplatte zu wechseln, obwohl es sich um eine Trägerplatte gleichen Typs handeln kann und der einzige Unterschied in den zugeführten Chips besteht. Bei bekannten Hybrid-Chipbondmaschinen werden die Chipträgerplatten einzeln gewechselt, was eine entsprechend lange Produktionsdauer mit sich bringt.

In der EP 0 447 082 B 1 der Anmelderin ist ein Chipträgerplatten-Wechselsystem angegeben zur Verwendung in einer Hybrid-Chipbondmaschine, und zwar insbesondere einer automatischen Hybrid-Chipbondmaschine. Ein automatischer Hybrid-Chipbonder weist dort ein Chipträgerplattensystem, eine Chipausstechsystem-Station und ein Chipaufnahme- und -montagesystem auf, das ein Chipgreifzangensystem oder ein Epoxy-Chipbonder sein kann.

Das Chipausstechsystem umfaßt gemäß der EP-A-0 447 083 der Anmelderin einen Träger, eine Vielzahl von Chipausstechköpfen, die an dem Träger angebracht sind, und eine Einrichtung zum schrittweisen Fortschalten des Trägers zum Fortschalten eines Kopfs in eine Betriebsposition. Die verschiedenen Köpfe weisen verschiedene Anordnungen von Chipausstechnadeln auf, die jeweils geeignet sind, um eine bestimmte Chipgröße oder einen bestimmten Chiptyp auszustechen. Nach dem Ausstechen wird der Chip von einem geeigneter Aufnehmer aufgenommen und zu einer Chipmontagestation verbracht.

Die Chipaufnahmestufe weist zweckmäßig ein Werkzeugwechselsystem auf, wie es in der EP-A-0 447 087 der Anmelderin beschrieben ist. Diese umfaßt einen Werkzeugsatz mit einer Vielzahl von Werkzeughaltern, in die jeweils ein Werkzeug eingesetzt ist und die zur Aufnahme durch einen Kopf ausgebildet sind. Der Kopf ist an einer Halterung angebracht und kann zwischen dem Werkzeugsatz, dem Chipausstechsystem und einer Chipmontagestation angetrieben werden. Der Werkzeugsatz kann angetrieben werden, um einen ausgewählten Werkzeughalter zu einer Station weiterzuschalten, an der er von dem Kopf aufgenommen werden kann.

Das Chipträgerplatten-Wechselsystem gemäß der o.a. EP 0 447 082 B1 weist auf:
(a) ein Magazin, um eine Vielzahl von Chipträgerplattenn zu speichern,
(b) eine Transportanordnung, die auf einem axialen Zapfen, der um seine Vertikalachse drehbar ist", angebracht ist und eine erste und eine zweite Einspanneinrichtung aufweist, die an einer drehbaren Halterung angebracht sind, wobei jede Einspanneinrichtung dazu ausgebildet ist, eine ausgewählte Chipträgerplatte von dem Magazin abzuholen, sie einem Chipausstechsystem der Chipbondmaschine zuzuführen, sie aus dem Chipausstechsystem wieder aufzunehmen, nachdem eine vorbestimmte Anzahl Chips ausgeworfen worden ist, und sie zu dem Magazin zurückzubringen,
(c) eine Schalteinrichtung zum Weiterbewegen der Trägerplatten in dem Magazin, so daß die gewählte Trägerplatte an einem Abholpunkt zur Abholung aus dem Magazin positioniert wird, und
(d) eine Schalteinrichtung zum Weiterdrehen der Transportanordnung um die genannte Vertikalachse.

Der Erfindung liegt die Aufgabe zugrunde, einen verbesserten Chipträgerplatten-Wechselmechanismus sowie ein Verfahren zum Betrieb eines solchen anzugeben, mit denen eine noch höhere Arbeitseffizienz und damit niedrigere Produktonskosten beim Chipbonden erreicht werden können.

Diese Aufgabe wird gemäß ihrem Vorrichtungsaspekt durch einen Chipträgerplatten-Wechselmechanismus mit den Merkmalen des Anspruchs 1 und in ihrem Verfahrensaspekt durch ein Betriebsverfahren mit den Merkmalen des Anspruchs 8 gelöst.

Die Erfindung schließt den grundlegenden Gedanken ein, den Zeitaufwand für den Transport zwischen dem Magazin, in dem die für den Produktionsprozeß bereitgestellten Chipträgerplatten aufgenommen sind, und dem Chipausstechsystem durch eine Kombination von Zuführ- und Abtransportvorgang weiter zu verringern.

Weiter schließt die Erfindung den Gedanken ein, hierzu den Aufbau des Chipträgerplatten-Wechselmechanismus zu modifizieren. Schließlich gehört zur Erfindung der Gedanke, diese Modifizierung an der Transportanordnung vorzunehmen, und zwar bezüglich der Anordnung der dort vorgesehenen Einspanneinrichtungen. Mit der vorgenommen Modifizierung, nämlich dem Übereinander-Anordnen der Einspanneinrichtungen in Kombination mit deren separater Steuer- bzw. Auslösbarkeit, wird die Realisierung der oben erwähnten Kombination von Zuführ- und Abtransportvorgang in einfacher Weise ausführbar.

Die vorgeschlagene Anordnung in Verbindung mit einer geeigneten Steuerung der Transportanordnung ermöglicht es, in einer dem Magazin benachbarten ersten Arbeitsstellung der Transportanordnung nahezu zeitgleich eine erste, zur Bearbeitung benötigte Chipträgerplatte aus dem Magazin zu entnehmen und eine zweite, aus der Arbeitsstation entnommene Chipträgerplatte in das Magazin abzulegen. Ebenso ermöglicht es die vorgeschlagene Anordnung, in einer zweiten, dem Chipausstechsystem benachbarten Arbeitsstellung unmittelbar aufeinanderfolgend eine abzutransportierende Chipträgerplatte zu entnehmen und die zuzuführende Chipträgerplatte mit den zu bearbeitenden Chips zu übergeben.

In einer bevorzugten Ausführung der Transportanordnung weisen die erste und zweite Einspanneinrichtung jeweils einen zwischen einem ersten und einem zweiten Abstand zu einer Grundstellung des Halters verfahrbaren Aufnehmer auf. Jedem Aufnehmer ist eine Klammer zum steuerbaren Festklemmen jeweils eines Chipträgerplattens oder zu deren Freigabe zugeordnet. Die Klammern sind vorzugsweise pneumatisch oder auch elektrisch betätigt, so daß die Transportanordnung leicht und schnell bewegbar und steuerbar ist und kompakt aufgebaut werden kann.

Die Chipträgerplatten haben insbesondere im wesentlichen die Form einer quadratischen Platte mit einer Öffnung im Inneren. Zwischen den Außenkanten der Platte und dieser Öffnung sind speziale Ausformungen vorgesehen, die sowohl die Aufnahme von Wafern als auch als auch von verschiedenen genormten Trägern für eine Mehrzahl von einzelnen Chips erlauben.

Die Aufnehmer der Transportanordnung sind an die Gestalt und Abmessungen eines Eckbereiches der Chipträgerplatte angepaßt und haben zwei zueinander senkrecht verlaufende Schenkel, welche durch eine viertelkreisförmige Vorderkante miteinander verbunden sind. Diese Vorderkante ist konzentrisch zu einer auf dem Aufnehmer liegenden Chipträgerplatte. Die Klammern der Aufnehmer sind nahe der Außenkanten der beiden Schenkel angeordnet und wirken zusammen mit Rastmitteln (speziell Ausnehmungen) auf der Oberfläche der Chipträgerplatte. Hierdurch wird zugleich eine exakte Positionierung der Chipträgerplatte bezüglich der Transportanordnung gewährleistet, die eine hohe Präzision bei der Übergabe an die Arbeitsstation bzw. in das Magazin sichert. Bevorzugt sind in zwei anderen Eckbereichen der Chipträgerplatte weitere Rostmittel zum Eingriff von Aufnehmern am Chipausstechsystem vorgesehen.

In der bevorzugten Ausführung des Wechselmechanismus sind die erste und zweite Einspanneinrichtung an einem gemeinsamen Grundkörper angebracht, welcher gegenüber dem Halter der Transportanordnung (in einem eingeschränkten Bereich) vertikal verfahrbar ist. Somit wird - im Zusammenwirken mit einer entsprechenden Ausführung des Magazins selbst - die Ausführung der vorgeschlagenen Ablege- und Entnahmevorgänge auf der Magazinseite ebenso wie die Übergabe und Entgegennahme von Chipträgerplatten am Chipausstechsystem gesichert.

Eine bevorzugte Ausführungsform eines Chipträgerplattensystems gemäß der Erfindung wird nachstehend unter Bezugnahme auf die beigefügten Zeichnungen näher beschrieben; in den Zeichnungen zeigen:
- Fig. 1: eine schematische Gesamtansicht der wichtigsten Komponenten einer automatischen Hybrid-Chipbondmaschine;
- Fig. 2: eine Draufsicht auf eine Chipträgerplatte und
- Fig. 3A bis 3C: drei Ansichten einer dreh- und verfahrbaren Transportanordnung.

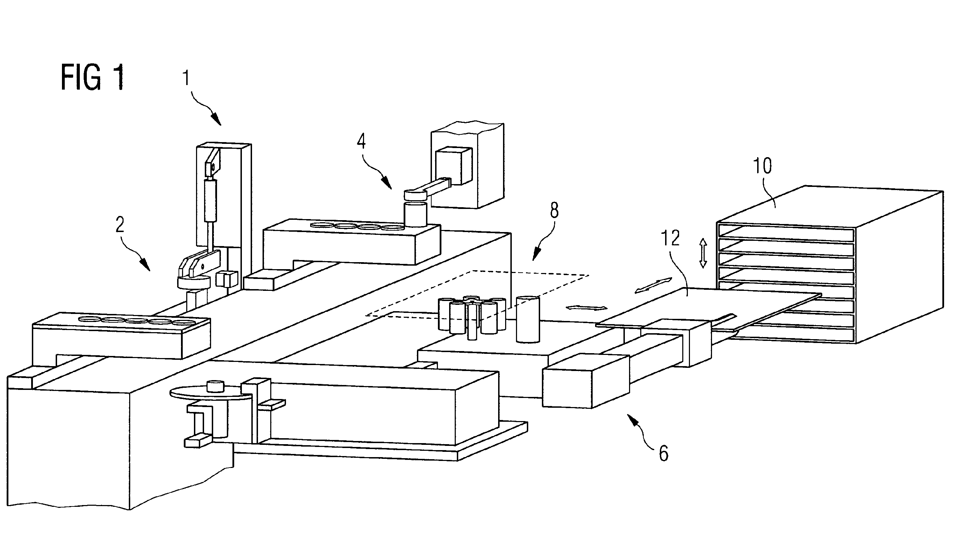

Fig. 1 zeigt in einer Prinzipdarstellung eine automatische Hybrid-Chipbondmaschine 1, die einerseits eine Epoxy-Druckstation (epoxy die bonder) 2 und andererseits eine Greifzangen-Chipmontagestation (die collet system) 4 als eigentliche Arbeitsstationen aufweist. Weiterhin umfaßt die Chipbondmaschine 1 ein Chipzuführungssystem 6 und ein Chipausstechsystem 8. Zum Chipzuführungssystem 6 gehört ein Magazin 10 zur Aufnahme einer Mehrzahl von Chipträgerplatten sowie der eigentliche Zuführungsmechanismus, welcher Gegenstand der Erfindung ist. Derartige Chipbondmaschinen sind seit längerem bekannt, so daß Aufbau und Zusammenwirken der Hauptkomponenten hier keiner weiteren Beschreibung bedürfen.

Ein Magazin 10 nimmt fünf oder mehr Chipträgerplatten 12 auf. Es hat einen Rahmen mit Einschubleisten für die Chipträgerplatten und ist vertikal verfahrbar, um ausgewählte Trägerplatten in eine Abgabeposition bzw. leere Fächer in eine Aufnahmeposition für zurücktransportierte Trägerplatten zu bringen.

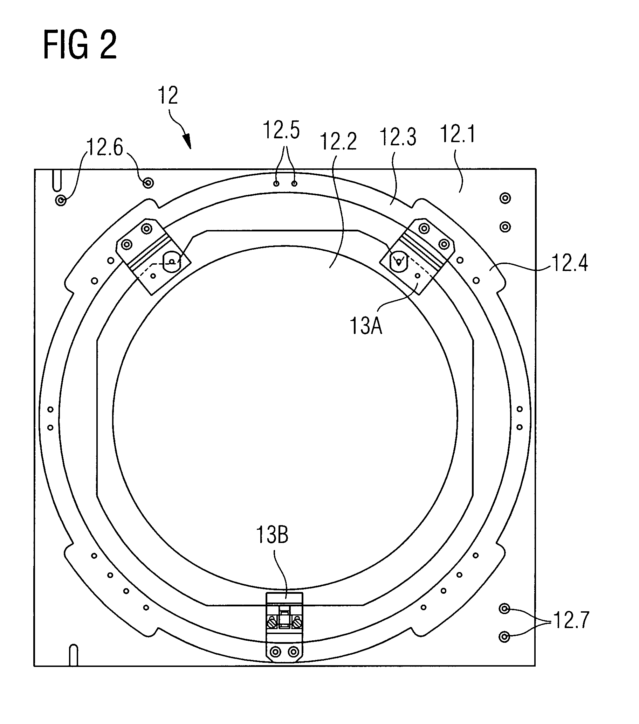

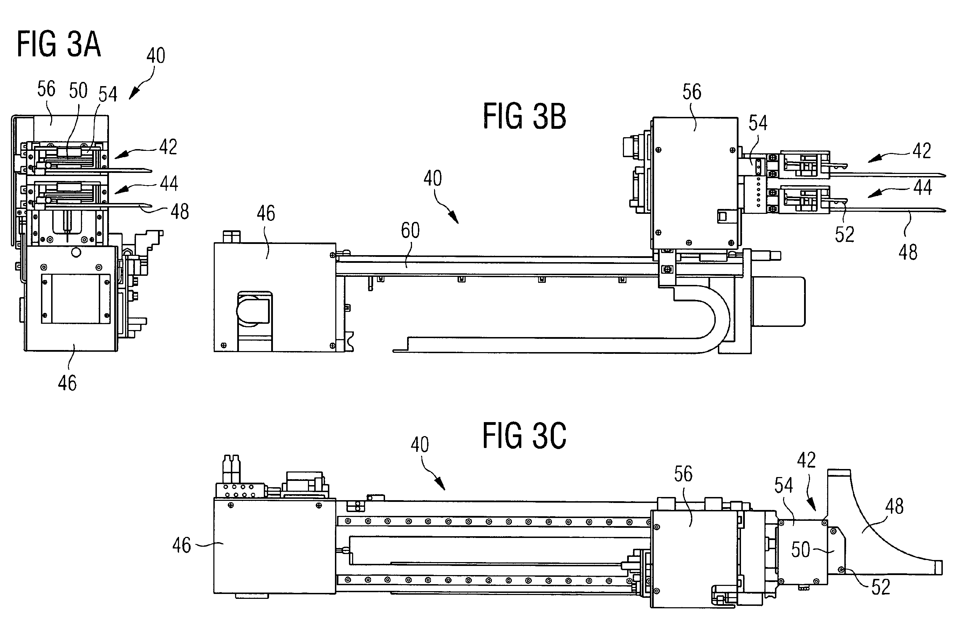

Fig. 2 zeigt in einer Draufsicht eine bevorzugte Chipträgerplatte 12 zum Einsatz in einer Hybrid-Chipbondmaschine 1 nach Fig. 1 in Verbindung mit einer Transportanordnung 40 nach Fig. 3A bis 3C.

In Fig. 3A bis 3C sind eine Vorderansicht, eine Seitenansicht bzw. eine Draufsicht einer Transportanordnung 40 als zentralem Bestandteil des Chipzuführungssystems 6 einer Hybrid-Chipbondmaschine nach Fig. 1 dargestellt. Diese Einheit umfaßt eine erste und eine zweite Einspanneinrichtung 42, 44, die übereinander an einem Grundkörper (Kopf) 46 angebracht sind.

Jede der ersten und zweiten Einspanneinrichtung 42, 44 weist einen Aufnehmer 48 auf, über dem ein Klemmstück 50 angeordnet ist. Jedes Klemmstück 50 weist zwei Zentrierkonusse 52 auf, die mit entsprechenden Vertiefungen an der Chipträgerplatte 12 (siehe Fig. 2) zusammenwirken. Der Aufnehmer 48 und das Klemmstück 50 sind von einer (nicht gezeigten) Feder 56 in die Offenstellung vorgespannt.

Die Federkraft wird durch eine pneumatisch wirkende (nicht dargestellte) Antriebseinrichtung überwunden, die das jeweilige Klemmstück 50 mit den darin angebrachten Zentrierkonussen 52 auf den zugehörigen Aufnehmer 48 zu bewegt. Hierdurch wird die jeweils zu ergreifende Chipträgerplatte zwischen beiden eingeklemmt und zugleich in ihrer Position präzise festgelegt.

Beide Einspanneinrichtungen 42, 44 sind an einem Gleitstück 54 montiert, welches in einem Einspanngehäuse 56 vertikal verfahrbar gelagert ist. Die Verfahrbarkeit des Gleitstücks 54 über einen vorbestimmten Verfahrbereich dient der leichten Übergabe einer dem Chipausstechsystem zuzuführenden Trägerplatte an deren Aufnehmer bzw. der leichten Übernahme einer bereits bearbeiteten Trägerplatte von dem Aufnehmer des Chipausstechsystems, insbesondere in zwei aufeinanderfolgenden Handhabungsschritten. Aus dem Grundkörper 46 erstreckt sich ein Ausleger 58, auf dem das Einspanngehäuse 56 und mit ihm die Einspanneinrichtungen 42, 44 längsverschieblich sitzen.

In einer geeigneten Steuerungs-Kombination zum Antrieb des Einspanngehäuses 56 auf dem Ausleger 60, des Gleitstücks 54 gegenüber dem Einspanngehäuse 50 und der Klemmstücken 50 gegenüber dem Aufnehmer 48 wird das Erfassen und Ablegen von zu transportierenden Chipträgerplattenn 12 im Magazin 10 bzw. am Chipausstechsystem 8 bewirkt. Der Transport zwischen diesen wird im wesentlichen durch die erwähnten Längsbewegungen des Einspanngehäuses 56 auf dem Ausleger 58, in Verbindung mit Vertikalbewegungen des Magazins 10 zur Zuführung einer ausgewählten Chipträgerplatte zur Abgabeposition oder eines leeren Faches zur Aufnahmeposition sowie in Verbindung mit Erfassungs- und Verschiebebewegungen mindestens eines Aufnehmers des (hier nicht genauer beschriebenen) Chipausstechsystems bewerkstelligt.

Die Chipträgerplatte 12 hat im wesentlichen die Form einer quadratischen Platte 12.1 mit einer zentralen kreisförmigen Ausnehmung 12.2. Diese ist von einer ringförmigen Nut 12.3 mit mehreren Erweiterungsbereichen 12.4 und einer Mehrzahl von Montagebohrungen 12.5 umgeben, in die (in verschiedenen möglichen Positionen) Werkstückhalter 13A bzw. 13B zu halten von Wafern oder zusätzlichen Trägern für eine Mehrzahl von Chips (nicht dargestellt) montiert sind. Zwei Sackbohrungen 12.6 in der Oberfläche der Platte 12.1 sind zum Eingriff der entsprechend angeordneten (Zentrierkonusse 52) an den Eingriffsstücken 42, 44 der Einspannanordnung (Fig. 3A bis 3C) vorgesehen, und zwei weitere Paare von Bohrungen 12.7 sind dazu vorgesehen, daß die Trägerplatte von einem Aufnehmer des Chipausstechsystems erfaßt und dort präzise positioniert werden kann.

Die dargestellte Chipträgerplatte stellt nur eine von vielen zweckmäßigen Ausführungen dar, welche an die verschiedenen, eingangs erwähnten Typen von Chips und Chipzuführungssystemen angepaßt sind. Es versteht sich daher, daß in einem vorgegebenen Chipträgerplatten-Wechselmechanismus lediglich die Außenabmessungen und die Lage und Gestalt von Eingriffselementen zum Transport der Chipträgerplatten invariant sind.

Im Sinne des an anderer Stelle beschriebenen und in den Verfahrensansprüchen spezifizierten Transportablaufes wird die Transportanordnung 40 des Wechselmechanismus 6 jeweils in eine erste Arbeitsstellung gebracht, in der die Einspanneinrichtungen 42, 44 jeweils eine aus der Arbeitsstation bzw. dem Chipausstechsystem kommende Chipträgerplatte im Magazin 10 ablegen und eine neue Chipträgerplatte aus diesem abholen können, bzw. eine zweite Arbeitsstellung, in der die zuletzt in der Station befindliche Chipträgerplatte aus dieser entnommen und nahezu zeitgleich die neu abgeholte Chipträgerplatte der Station zugeführt wird.

Im Magazin 10 wird die Chipträgerplatte 12 von einem Gleichstrommotor in die vertikale Position angetrieben, in der eine ausgewählte Chipträgerplatte 12 sich in der korrekten vertikalen Lage zur Zuführung zu der drehbaren Transportanordnung 40 befindet.

Die entsprechende Chipträgerplatte wird ergriffen und aus dem Magazin genommen, und danach wird durch geeignetes Verfahren der Chipträgerplatten 12 im Magazin 10 sowie des Gleitstücks 54 gegenüber dem Einspanngehäuse 56 der Transportanordnung 40 die soeben zurückgebrachte Trägerplatte von der Transportanordnung freigegeben und in einem freien Fach im Magazin abgelegt. Die Reihenfolge der beiden Vorgänge kann auch umgekehrt sein. Der Entnahme- und Bestückungsvorgang in der Arbeitsstation bzw. dem Chipausstechsystem 8 ist den Figuren nicht zu entnehmen, ergibt sich für den Fachmann aber aus dem Aufbau der Transportanordnung und den oben gegebenen Erläuterungen zum Verfahrensablauf.

Die beschriebenen Entnahme-, Bewegungs- und Ablageschritte der Trägerplatten werden programmgesteuert ausgeführt, wobei eine ausgefeilte Sensorik Fehlsteuerungen - beispielsweise die Ablage einer aus dem Chipausstechsystem zurückkehrenden Trägerplatte in ein bereits belegtes Fach des Magazins - zuverlässig verhindert. Es versteht sich, daß auch die Auswahl bestimmter Trägerplatten aus dem Magazin und anschließend das Ausstechen vorbestimmter Chips von der jeweiligen Unterlagen (Trägerfolie o. ä.) im Chipausstechsystem auf der Grundlage eines vorgespeicherten Bestückungsschemas erfolgt.

Durch Ausführen des oben beschriebenen Arbeitszyklus ist es möglich, den Hybrid-Chipbonder mit einer stark verringerten Abschaltzeit zwischen dem Bonden verschiedener Chiptypen zu betreiben.

### Bezugszeichenliste

- 1: Hybrid-Chipbondmaschine
- 2: Epoxy-Druckstation (epoxy die bonder)
- 4: Greifzangen-Chipmontagestation (die collet system)
- 6: Chipzuführungssystem
- 8: Chipausstechsystem
- 10: Magazin
- 12: Chipträgerplatte
- 12.1: quadratische Platte
- 12.2: zentrale Ausnehmung
- 12.3: Nut
- 12.4: Erweiterungsbereich
- 12.5: Montagebohrung
- 12.6, 12.7: Bohrung (Eingriffsmittel)
- 13A; 13B: Werkstückhalter
- 40: Transportanordnung
- 42, 44: Einspanneinrichtung
- 46: Grundkörper (Kopf)
- 48: Aufnehmer
- 50: Klemmstück
- 52: Zentrierkonus
- 54: Gleitstück
- 56: Einspanngehäuse
- 58: Ausleger

## Patentansprüche

1. Chipträgerplatten-Wechselmechanismus, insbesondere zur Verwendung in einer Hybrid-Chipbondmaschine (1), mit:
- einer Mehrzahl von Chipträgerplatten (12),
- einem Magazin (10) zur Speicherung der Mehrzahl von Chipträgerplattenn (12),
- einer Transportanordnung (40), die eine erste und zweite Einspanneinrichtung (42, 44) aufweist, welche an einem bewegbaren Halter (46) angeordnet sind, wobei die Transportanordnung dazu ausgebildet ist, eine ausgewählte Chipträgerplatte aus dem Magazin zu entnehmen, sie einer Arbeitsstation, insbesondere einem Chipausstechsystem (8), der Chipbondmaschine zuzuführen, sie aus der Arbeitsstation nach einem Arbeitsgang wieder aufzunehmen und sie im Magazin abzulegen,
- einer Steuereinrichtung zum Weiterbewegen der Chipträgerplatten in dem Magazin derart, daß die ausgewählte Chipträgerplatte an einem Abholpunkt zur Abholung aus dem Magazin positioniert wird, und
- einer Steuereinrichtung zum Bewegen des Halters der Transportanordnung,
**dadurch gekennzeichnet, daß**
die erste und zweite Einspanneinrichtung (42, 44), insbesondere in vertikaler Ausrichtung miteinander, übereinander an dem Halter (46) angeordnet und einzeln zur Freigabe oder zum Festklemmen jeweils einer Chipträgerplatte in ein und derselben Winkelstellung des Halters ausgebildet sind.

2. Chipträgerplatten-Wechselmechanismus nach Anspruch 1,
**dadurch gekennzeichnet, daß**
die erste und zweite Einspanneinrichtung (42, 44) jeweils einen Aufnehmer (48) mit einer pneumatisch oder elektrisch betätigten Klammer (50, 52) zum steuerbaren Festklemmen einer Chipträgerplatte (12) oder zum Freigeben derselben aufweist.

3. Chipträgerplatten-Wechselmechanismus nach Anspruch 1 oder 2,
**dadurch gekennzeichnet, daß** die Chipträgerplatten (12) als Platten (12.1) mit einer im wesentlichen quadratischen Außenform und Eingriffsmitteln, insbesondere Ausnehmungen (12.6, 12.7), zum Eingriff der Einspanneinrichtungen der Transportanordnung sowie von Haltemitteln des Chipausstechsystems ausgebildet sind.

4. Chipträgerplatten-Wechselmechanismus nach einem der vorangehenden Ansprüche,
**dadurch gekennzeichnet, daß**
die Chipträgerplatten (12) zur Aufnahme aller herkömmlichen Chipträger, insbesondere vom Typ des Waffelpacks, Gelpacks oder Trägerfilmrahmen, ausgebildet sind.

5. Chipträgerplatten-Wechselmechanismus nach einem der vorangehenden Ansprüche,
**dadurch gekennzeichnet, daß**
die erste und zweite Einspanneinrichtung (42, 44) an einem gemeinsamen Grundkörper (54) angebracht sind, welcher gegenüber einem Gehäuse (56) der Transportanordnung (40) vertikal verfahrbar ist.

6. Verfahren zum Betrieb des Chipzuführungs-Wechselmechanismus einer Hybrid-Chipbondmaschine, insbesondere nach einem der vorangehenden Ansprüche,
**dadurch gekennzeichnet, daß**
ein Schritt des Entnehmens einer ausgewählten Chipträgerplatte aus einem Magazin und ein Schritt des Ablegens einer aus einer Arbeitsstation entnommenen weiteren Chipträgerplatte unmittelbar aufeinanderfolgend in einer ersten Arbeitsstellung einer Transportanordnung des Wechselmechanismus und
ein Schritt der Übergabe der aus dem Magazin entnommenen Chipträgerplatten in die Arbeitsstation sowie ein Schritt des Aufnehmens der bearbeiteten Chipträgerplatte aus der Arbeitsstation in dieser oder der umgekehrten Reihenfolge in einer zweiten Arbeitsstellung der Transportanordnung ausgeführt werden,
derart, daß jeder Transportvorgang vom Magazin zur Arbeitsstation und umgekehrt während der Handhabung einer Chipträgerplatte in der Arbeitsstation ausgeführt wird.

7. Verfahren nach Anspruch 6,
**dadurch gekennzeichnet, daß**
jeder Transportvorgang sowohl der Zuführung einer ausgewählten Chipträgerplatte zur Arbeitsstation als auch dem Zurückbringen einer Chipträgerplatte von der Arbeitsstation zum Magazin dient.

8. Verfahren nach Anspruch 6 oder 7,
**dadurch gekennzeichnet, daß**
die Transportanordnung zwischen der ersten und zweiten Arbeitsstellung und umgekehrt nur eine geradlinige Bewegung ausführt.
